# FASCICULE DE BREVET EUROPEEN

(11) **EP 2 726 832 B1**
(45) Date de publication et mention de la délivrance du brevet: **02.11.2016**
(21) Numéro de dépôt: 12730972.2
(22) Date de dépôt: 29.06.2012
(51) Int. Cl.: B82Y 10/00, H01L 29/8605, H01L 29/16, G01L 1/22, G01P 15/12, H01L 29/06

(54) **DISPOSITIF RESISITIF A JAUGE DE CONTRAINTE A NANOFILS DE SILICIUM ET PROCEDE D'OPTIMISATION DE LA CONSOMMATION ELECTRIQUE D'UN TEL DISPOSITIF**
RESISTIVE VORRICHTUNG MIT EINEM SILICIUM-NANODRAHT-DEHNUNGSMESSSTREIFEN UND VERFAHREN ZUR OPTIMIERUNG DES STROMVERBRAUCHS EINER SOLCHEN VORRICHTUNG
RESISTIVE DEVICE COMPRISING A SILCON-NANOWIRE-COMPRISING STRAIN GAUGE AND METHOD FOR OPTIMIZING THE ELECTRICAL CONSUMPTION OF SUCH A DEVICE

(30) Priorité: 30.06.2011 FR 1155884
(43) Date de publication de la demande: 07.05.2014
(73) Titulaire: Centre National de la Recherche Scientifique (C.N.R.S.), 75016 Paris (FR); Université du Sud Toulon-Var, 83957 La Garde Cedex (FR); Université d'Aix-Marseille, 13007 Marseille 7 (FR)
(72) Inventeur: RAHAJANDRAIBE, Wenceslas, F-13013 Marseille (FR); MEILLERE, Stéphane, F-83890 Besse Sur Issole (FR); KUSSENER, Edith, F-83200 Le Revest les Eaux (FR); BARTHELEMY, Hervé, F-83610 Collobrieres (FR)
(74) Mandataire: Lavoix
(86) Numéro de dépôt international: PCT/EP2012/062774
(87) Numéro de publication internationale: WO 2013/001081

(56) Documents cités:
- EP-A2- 2 008 965
- US-B1- 6 433 524
- MILE E ET AL: "In-plane nanoelectromechanical resonators based on silicon nanowire piezoresistive detection", NANOTECHNOLOGY, IOP, BRISTOL, GB, vol. 21, no. 16, 23 avril 2010 (2010-04-23), page 165504, XP020174814, ISSN: 0957-4484
- MASSIMILIANO BELLONI ET AL: "Low-power ripple-free chopper amplifier with correlated double sampling de-chopping", IEEE INTERNATIONAL SYMPOSIUM ON CIRCUITS AND SYSTEMS. ISCAS 2010 - 30 MAY-2 JUNE 2010 - PARIS, FRANCE, IEEE, US, 30 mai 2010 (2010-05-30), pages 765-768, XP031724696, ISBN: 978-1-4244-5308-5
- YOSHIDA T ET AL: "A 1V supply 50nV/Hz noise PSD CMOS amplifier using noise reduction technique of autozeroing and chopper stabilization", VLSI CIRCUITS, 2005. DIGEST OF TECHNICAL PAPERS. 2005 SYMPOSIUM ON, IEEE, PISCATAWAY, NJ, USA, 16 juin 2005 (2005-06-16), pages 118-121, XP010818349, DOI: 10.1109/VLSIC.2005.1469347 ISBN: 978-4-900784-01-7

## Description

L'invention a pour domaine celui des dispositifs résistifs du type comportant au moins une jauge de contrainte à nanofils de silicium, un moyen d'alimentation comportant au moins une source de courant propre à générer un courant de polarisation de la jauge, et des moyens d'acquisition propres à délivrer un signal de mesure à partir duquel la variation de la résistance électrique de la jauge peut être déterminée.

De tels dispositifs sont connus, par exemple de l'article MILE E ET AL, « in-plane nanoelectromechanical resonators based on silicon nanowire piezoresitive détection », NANOTECHNOLOGY, IOP, Bristol, GB, Vol, 21, no. 16, 23 avril 2010, page 165504. Ils sont par exemple utilisés en tant que capteur inertiel. L'élément sensible d'un tel dispositif comporte un ou plusieurs nanofils de silicium, chaque fil étant utilisé comme jauge de contrainte. La détection de la contrainte s'effectue par la mesure de la variation de la résistance de la jauge, lorsque celle-ci est par exemple soumise à une accélération.

Pour ce faire, la jauge doit être polarisée au sens où un courant de polarisation doit circuler à travers la nanofil de silicium.

Le signal de mesure correspond alors à la variation de tension aux bornes de la résistance que constitue la jauge polarisée.

Mais, la sensibilité du dispositif est limitée par le rapport signal de mesure sur bruit de fond (SNR pour « Signal to Noise Ratio » en anglais).

Une plus grande sensibilité, c'est-à-dire un SNR plus important, requiert une plus grande amplitude du signal de mesure qui est obtenue, toutes choses égales par ailleurs, par une augmentation du courant de polarisation de la jauge. Mais, l'augmentation du courant de polarisation conduit à une plus grande consommation électrique du dispositif.

Ainsi, de manière générale, la sensibilité du dispositif et sa consommation électrique sont corrélées.

De plus, de manière plus spécifique, dans certaines applications envisagées pour ces dispositifs, telles que capteurs inertiels corporels destinés à la détection du mouvement humain, l'information relative au mouvement est contenue dans la partie basse fréquence du signal de mesure délivré par le dispositif. Dans ces applications, la bande passante d'intérêt va, quasiment, du continu, jusqu'à quelques centaines de kilo Hertz.

Or, le bruit de fond d'un tel dispositif résulte de la superposition des bruits thermiques de la jauge et du moyen électronique d'acquisition, mais également d'un bruit intrinsèque de la jauge. Ce bruit intrinsèque de la jauge est en 1/f, c'est-à-dire proportionnel à l'inverse de la fréquence du signal mesuré. Plus la fréquence du signal de mesure est faible, plus le bruit est important.

Pour obtenir une sensibilité acceptable à basse fréquence, il faut donc que l'amplitude du signal de mesure soit importante. Il faut par conséquent que le courant de polarisation des nanofils de silicium soit élevé. Ceci entraîne une consommation électrique supplémentaire du dispositif si on souhaite l'utiliser à basse fréquence.

Or, la consommation électrique d'un tel dispositif résistif est un paramètre qui doit être minimisé. En effet, à côté des dispositifs résistifs, il existe une autre famille de dispositifs, les dispositifs capacitifs. Ceux-ci sont déjà largement utilisés en particulier parce qu'ils ne nécessitent pas de courant de polarisation pour fonctionner. Cela les rend fortement attractifs sur le plan de la consommation électrique totale du système qui les intègre.

En revanche, la variation de la capacité avec la contrainte mécanique restant faible, ces dispositifs capacitifs intègrent nécessairement de fortes capacités qui sont, par nature, encombrantes. Ceci limite les possibilités d'intégration des systèmes utilisant de tels dispositifs capacitifs.

Ainsi, pour les dispositifs résistifs à nanofil de silicium, qui sont des dispositifs compacts, se pose le problème de la réduction de leur consommation électrique sans pour autant dégrader leur SNR. La résolution de ce problème est déterminante pour que les dispositifs résistifs à nanofil de silicium soient utilisés plus largement dans l'industrie.

Il est par ailleurs connu, par exemple du document US 6 433 524 B1, de munir un dispositif résistif d'un moyen de hachage propre à ne faire circuler le courant de polarisation généré par une source à travers une jauge que durant une fraction du cycle de fonctionnement.

L'invention a donc pour but de pallier, en tout ou partie, ce problème.

Pour cela l'invention a pour objet un dispositif résistif, un procédé d'optimisation et un procédé d'utilisation selon les revendications.

L'invention sera mieux comprise à la lecture de la description qui va suivre d'un mode de réalisation particulier, donnée uniquement à titre d'exemple et faite en se référant aux dessins annexés sur lesquels :
- la Figure 1 est une représentation schématique du montage électrique d'un mode de réalisation préféré d'un dispositif résistif à nanofil de silicium ;
- la Figure 2 est un chronogramme représentant l'évolution temporelle de différents signaux de commande du montage de la Figure 1 ;
- la Figure 3 est un graphe représentant le bruit de fond affectant le dispositif de la Figure 1 pour deux valeurs différentes du courant de polarisation des jauges ;
- la Figure 4 est un graphe représentant l'évolution du rapport signal sur bruit (SNR) en fonction de la valeur du courant de polarisation ;
- la Figure 5 est un schéma blocs du procédé d'optimisation de la consommation électrique du dispositif de la Figure 1 ; et
- la Figure 6 est une représentation graphique partielle d'un mode de réalisation particulier du montage électrique de la Figure 1.

Le dispositif résistif selon l'invention est un capteur inertiel à détection par nanofils de silicium. Il comporte, en tant qu'élément sensible, une masse sismique suspendue, de façon élastique, par deux nanofils de silicium s'étendant de part et d'autre de la masse, le long d'une direction X.

Les nanofils de silicium, lorsqu'ils sont traversés par un courant de polarisation I_{bias} adapté, constituent des jauges de contrainte dont la variation de résistance électrique permet de déterminer l'accélération selon la direction X de la masse sismique.

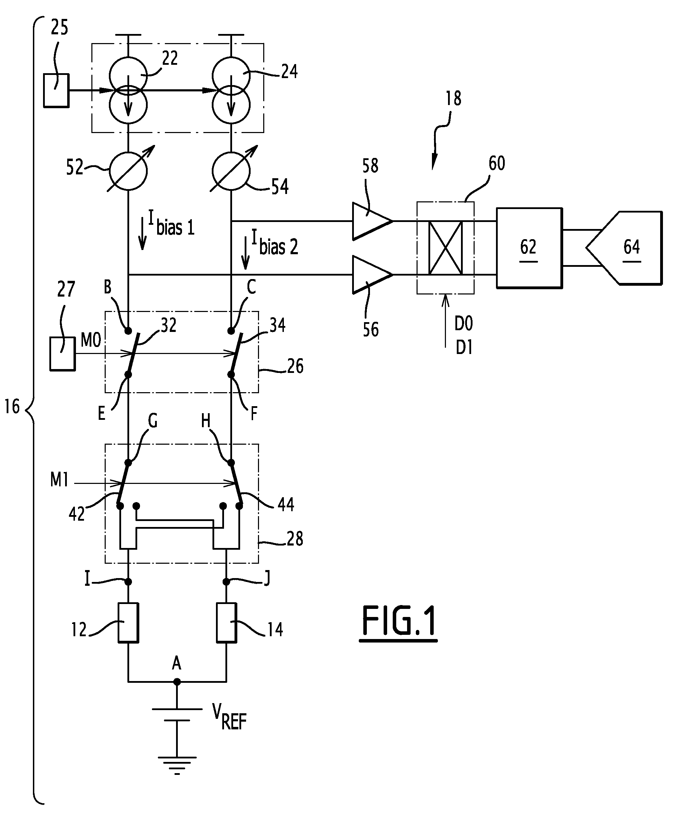

La Figure 1 représente le montage électrique du dispositif résistif selon l'invention. Celui-ci est référencé de manière générale par le chiffre 10.

Le dispositif 10 comporte deux jauges 12 et 14, un moyen d'alimentation 16 propre à générer un courant continu pour la polarisation des jauges 12 et 14, ainsi que des moyens d'acquisition 18 permettant de générer un signal de mesure à partir duquel il est possible de remonter à la variation de résistance de chacune des jauges et de déterminer l'accélération de la masse sismique.

D'une manière générale, le montage de la Figure 1 est du type différentiel avec compensation du mode commun. D'autres montages, connus de l'homme du métier, sont envisageables. On citera par exemple les montages dénommés « stand alone résistance », « push pull bridge », « wheatstone bridge », etc.

Le principal avantage d'un montage différentiel avec compensation du mode commun est de permettre la réduction de la dérive en température des jauges 12 et 14. Cette compensation du mode commun est préférable bien qu'elle ne soit pas indispensable à l'invention.

Ainsi, dans le montage de la figure 1, l'une des bornes de chaque jauge 12, 14, est connectée à un noeud A porté à un potentiel de référence VREF.

Le moyen d'alimentation 16 comporte deux sources de courant, respectivement 22 et 24, un moyen 25 de réglage de l'intensité du courant I_{bias1}, I_{bias2}, délivré par chacune des sources 22, 24, un étage de hachage 26 aux bornes d'entrée B et C duquel sont respectivement connectées les sources 22 et 24, un moyen 27 de réglage du rapport cyclique du moyen de hachage 26, et un étage de stabilisation par découpage 28 dont les bornes d'entrée G et H sont connectées aux bornes de sortie E et F du moyen de hachage 26, et dont les bornes de sortie I et J sont respectivement connectées aux bornes des jauges 12 et 14 qui ne sont pas connectées au noeud A.

Le moyen de hachage 26 est équivalent à une paire d'interrupteurs commandés respectivement 32 et 34. Ces deux interrupteurs sont commandés par le même signal de commande de hachage M0 émis par le moyen 27. Lorsqu'il est fermé, l'interrupteur 32 permet l'application du courant I _{bias 1} généré par la source 22 sur la borne d'entrée G de l'étage 28.

De manière similaire, lorsqu'il est fermé l'interrupteur 34 permet l'application du courant I _{bias 2} généré par la source 24 à la borne d'entrée H de l'étage 28.

Le moyen de découpage 28 est équivalent à une paire de bascules commandées à deux états, respectivement 42 et 44.

Dans le premier état, la première bascule 42 permet de connecter la première borne d'entrée G à la première borne de sortie I tandis que la seconde bascule 44 permet simultanément de connecter la seconde borne d'entrée H à la seconde borne de sortie J du moyen 28.

Dans le second état, la première bascule 42 permet de connecter la première borne d'entrée G à la seconde borne de sortie J, tandis que la seconde bascule 44 permet simultanément de connecter la seconde borne d'entrée H à la première borne de sortie I du moyen 28.

L'état des bascules 42 et 44 est commandé par un même signal de contrôle de découpage M1.

Les moyens d'acquisition 18 délivrent le signal de mesure.

Les moyens 18 comportent un moyen de mesure du courant de polarisation comportant deux capteurs de courant respectivement 52 et 54. Chaque capteur est disposé en aval de l'une des sources de courant 22 et 24.

Les moyens 18 comportent également un moyen de mesure de la tension aux bornes des jauges. Il comporte des amplificateurs respectivement des tensions prélevées au noeud B, amplificateur 56, et au noeud C, amplificateur 58 ; en aval des amplificateurs, un moyen de démodulation 60 représenté schématiquement ; en aval du moyen de démodulation 60, un filtre passe bas 62 ; et en aval du filtre 62, un moyen de numérisation, tel qu'un ADC 64, propre à numériser les signaux générés en sortie du filtre passe bas.

La fonction du moyen de démodulation 60 est la démodulation des signaux de tension amplifiés résultant de la modulation de l'application des courants de polarisation aux jauges 12 et 14 par le moyen de découpage 28. Le moyen 60 est commandé par deux signaux de commande de démodulation respectivement D0 et D1.

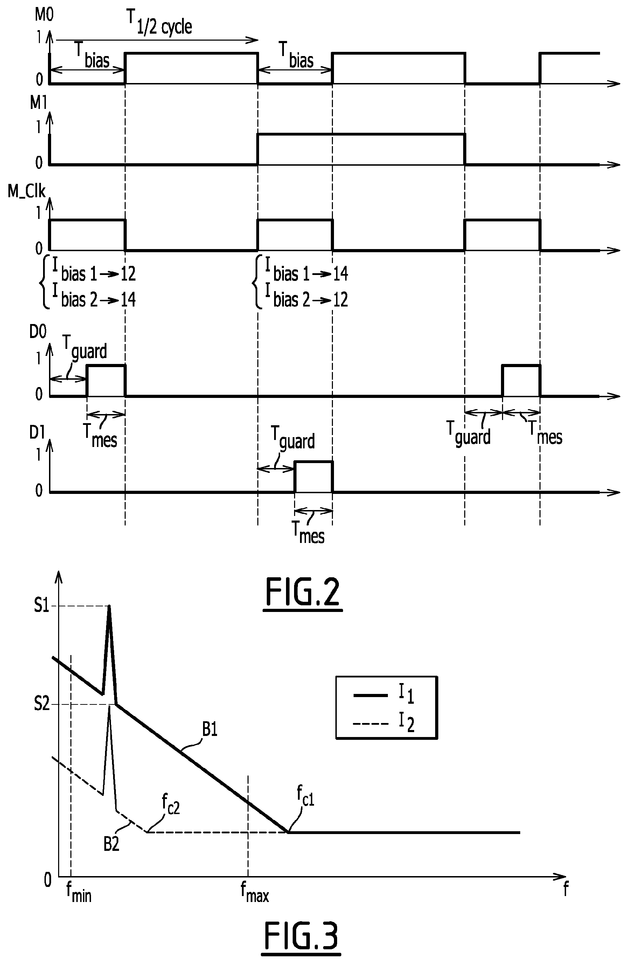

Les signaux de commande pour le fonctionnement du dispositif de la Figure 1 sont représentés à la Figure 2.

Le signal de commande de hachage M0 est un signal créneau entre les valeurs 0 et 1. Il prend la valeur 0 sur une première période T_{bias} d'un demi cycle de fonctionnement, et la valeur 1 sur le reste de ce demi cycle de fonctionnement.

Le rapport de la durée T_{bias} sur la durée d'un demi cycle T_{1/2 cycle} correspond au rapport cyclique.

Lorsque le signal de commande de hachage M0 a la valeur 0, les interrupteurs 32 et 34 sont fermés de sorte que le courant I _{bias 1} généré par la source 22 est appliqué à la première borne d'entrée G de l'étage 28, tandis que le courant I _{bias 2} généré par la source 24 est appliqué à la seconde borne d'entrée H de l'étage 28.

Lorsque le signal de commande M0 prend la valeur 1, les interrupteurs 32 et 34 sont ouverts.

Le signal de commande de découpage M1 est un signal créneau entre les valeurs 0 et 1. Il prend la valeur 0 sur le premier demi-cycle et la valeur 1 sur le second demi-cycle suivant de fonctionnement du dispositif 10.

Lorsque le signal de commande M1 prend la valeur 0, les première et seconde bascules 42 et 44 sont dans le premier état. Le courant I _{bias 1} circule alors dans la jauge 12 et le courant I _{bias 2} dans la jauge 14.

En revanche, lorsque le signal de commande M1 prend la valeur 1, les première et seconde bascules sont dans le second état. Le courant I _{bias 2} circule dans la jauge 12 et le courant I _{bias 1}, dans la jauge 14.

Le troisième chronogramme de la Figure 2 représente la combinaison des états des étages 26 et 28 :
- pendant une première période T_{bias} du premier demi-cycle, le courant I _{bias 1} traverse la première jauge 12 tandis que le courant I2 traverse la seconde jauge 14 ;
- pendant le reste de ce premier demi-cycle aucun courant ne circule à travers les jauges ;
- durant une première période T_{bias} du second demi-cycle, le courant I _{bias 1}circule dans la seconde jauge 14, tandis que le second courant I _{bias 2} circule à travers la première jauge 12 ; et,
- durant le reste de ce second demi-cycle aucun courant ne circule dans les jauges.

Sur la Figure 2, on a également représenté les signaux D0 et D1 de l'étage de démodulation 60. Ces signaux D0 et D1 sont corrélés aux signaux M0 et M1. Le signal D0 est essentiellement nul sauf pendant un intervalle Tₘₑₛ inclus dans la première période du premier demi-cycle.

De manière similaire, le signal D1 est essentiellement nul, sauf pendant un intervalle de temps Tₘₑₛ inclus dans la première période du second demi-cycle.

Ainsi, lors de l'utilisation du dispositif 10, les jauges 12 et 14 sont polarisées par un courant électrique durant une fraction du cycle d'utilisation du dispositif. Dit autrement, les jauges sont polarisées alternativement par les courants I _{bias 1} et I _{bias 2} pendant la durée de la mesure, cette mesure n'étant effectuée que pendant une période de temps T_{bias} réduite par rapport au cycle d'utilisation (période d'échantillonnage) du dispositif. Pendant le reste du temps, aucun courant ne circule dans les jauges qui ont donc une consommation électrique nulle.

Cette capacité de n'utiliser les jauges que sur une fraction du cycle est due au temps de réponse des nanofils de silicium qui est extrêmement bas par rapport au temps de réponse plus élevé des moyens électroniques d'acquisition 18.

Ainsi, le moyen de hachage permet de réduire la consommation électrique du dispositif en ne polarisant que temporairement les jauges.

Mais, il a été découvert de manière surprenante, que le fait d'appliquer un courant de polarisation de manière alternative à travers une jauge du type nanofil de silicium atténue fortement le bruit intrinsèque de cette jauge. Des observations expérimentales ont été faites pour montrer que pour les fréquences faibles, il n'y a pas de dégradation du rapport signal sur bruit lorsque l'on réduit le rapport cyclique de 75 à 25%. Le fait de réduire le rapport cyclique conduit à une diminution de la puissance moyenne du courant de polarisation et, par conséquent, à une diminution de la puissance moyenne du signal de mesure. Mais pourtant, le SNR reste sensiblement constant. On déduit donc que le hachage réduit la puissance du bruit intrinsèque de la jauge.

Pour profiter pleinement de cet effet d'atténuation du bruit intrinsèque en 1/f de la jauge, le courant de polarisation I_{bias} est réglé au moyen du moyen de réglage 25 de la manière suivante.

La Figure 3 représente pour deux valeurs du courant de polarisation I₁, I₂, le graphe du bruit B1, respectivement B2, affectant le signal de mesure S1, respectivement S2.

Dans une première partie du graphe, partie correspondant aux fréquences faibles, le bruit est dominé par le bruit intrinsèque de la jauge en 1/f. Au-delà d'une fréquence caractéristique, appelée fréquence de coin fc1, le bruit est dominé par le bruit thermique de la jauge et des moyens électroniques d'acquisition, qui est un bruit sensiblement constant en fonction de la fréquence.

Lorsque le courant de polarisation est diminué, la fréquence de coin se déplace vers les fréquences faibles (fc2<fc1).

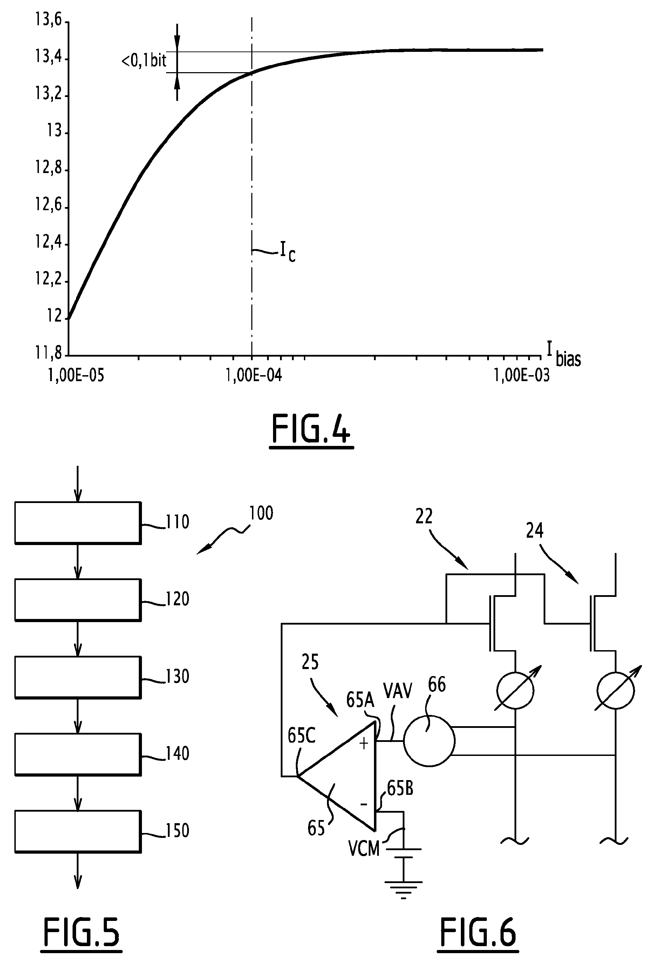

On a représenté sur la Figure 4, un graphe représentant le SNR en fonction de l'intensité du courant de polarisation I_{bias}.

On constate que, lorsque le courant de polarisation diminue, le rapport signal sur bruit reste dans un premier temps sensiblement constant jusqu'à une valeur critique du courant de polarisation, I_{c}, puis diminue, dans un second temps, en-deçà de cette valeur critique.

Ceci est dû au fait que, pour les courants de polarisation supérieurs à cette valeur critique I_{c}, le bruit de fond est dominé par le bruit intrinsèque en 1/f qui est dans un rapport constant avec l'amplitude du signal de mesure comme indiqué ci-dessus.

En revanche, pour les courants de polarisation inférieurs à cette valeur critique I_{c}, le bruit de fond est dominé par le bruit thermique. Le bruit thermique étant constant, lorsque le courant de polarisation diminue, l'amplitude du signal de mesure diminue et le SNR ne peut que diminuer.

On en déduit le procédé suivant d'optimisation du courant de polarisation des dispositifs.

Ce procédé est représenté à la Figure 5. La première étape 110 consiste à définir la contrainte de consommation totale du dispositif, c'est-à-dire non seulement la consommation pour la polarisation des jauges 12 et 14, mais également la consommation des moyens d'acquisition 18.

Pour bénéficier de l'atténuation du bruit intrinsèque par le hachage du courant de polarisation, il faut un courant de polarisation supérieur à la valeur critique I_{c}. Puisque l'on souhaite minimiser le courant de polarisation, il faut donc se placer au point de fonctionnement correspondant à cette valeur critique I_{c}. On montre que cette valeur critique correspond sensiblement à un courant de polarisation tel que la fréquence supérieure fmax de la bande passante d'intérêt soit égale à la fréquence de coin fc.

On détermine ainsi, à l'étape 120, la valeur initiale du courant de polarisation, telle que la fréquence de coin du bruit affectant le signal de mesure corresponde à la fréquence maximale de la bande passante d'intérêt. Lors de l'utilisation du dispositif, le moyen de réglage 25 permet d'ajuster la valeur des courants de polarisation générés par les sources, à cette valeur déterminée.

A l'étape 130, on détermine la valeur du rapport cyclique du moyen de hachage de manière à réduire la consommation électrique. Il s'agit de minimiser le rapport cyclique pour obtenir la consommation électrique la plus faible, tout en conservant une certaine marge par rapport à la consommation la plus faible possible de manière à tenir compte, en fonction du montage choisi, du temps de réponse de l'électronique (T_{guard} sur la Figure 2). Lors de l'utilisation du dispositif, le moyen de réglage 27 permet d'ajuster la valeur du rapport cyclique du moyen de hachage, à cette valeur déterminée.

Enfin, à l'étape 140, on détermine la consommation électrique des jauges à partir des valeurs déterminées du courant de polarisation et du rapport cyclique. Cette consommation est soustraite de la consommation totale définie à l'étape 110 pour obtenir une consommation électrique que l'on peut affecter aux moyens d'acquisition.

Cette consommation électrique sert alors de contrainte pour l'élaboration de la chaîne électronique d'amplification, de filtrage et de numérisation permettant d'obtenir le signal de mesure (étape 150).

Au cours de l'utilisation du dispositif, le point de fonctionnement optimal est, par exemple, le suivant :
- I_{bias1} = I_{bias2} = 1/2.10⁻⁴ A
- R = 2,5 kΩ et ΔR/R=+/- 3,6.10⁻²

Où ΔR/R est la sensibilité du nanofil de silicium.
- gamme des fréquences fₘᵢₙ =0,1 Hz ; fₘₐₓ = 1000 Hz
- SNR = 74 dB
- I total = 2 x I_{bias} + I_{acq} = 120.10⁻⁶A

Où I_{acq} est l'intensité du courant dans les moyens d'acquisition.
- la puissance totale du dispositif : P=15 µW.

De nombreuses variantes du dispositif sont à envisager.

Dans le mode de réalisation illustré sur la Figure 6, illustrant uniquement les sources de courant 22, 24 et un moyen de réglage associé, ce dernier comprend un amplificateur différentiel 65 relié aux sources de courant 22, 24 pour réaliser une contre-réaction, de manière à réguler le courant fourni par les sources de courant 22, 24.

L'amplificateur différentiel 65 est par exemple un amplificateur opérationnel.

L'amplificateur différentiel 65 comprend une entrée 65A recevant une tension moyenne VAV correspondant à la moyenne des tensions prises en entrée des jauges 12, 14 (ou en sorties des sources de courant 22, 24), et une entrée 65B recevant une tension de commande VCM. Tel que représentées sur la Figure 6, l'entrée 65A est non-inverseuse et l'entrée 65B est inverseuse. En variante, l'entrée 65A est inverseuse et l'entrée 65B est non-inverseuse.

La tension moyenne VAV est fournie par un module de moyenne 66 comprenant deux entrée 66A, 66B chacune reliée à l'entrée d'une jauge 12, 14 respective (ou à la sortie d'une source de courant 22, 24 respective) et une sortie 66C reliée à l'entrée 65A entrée de l'amplificateur différentiel 65, le module de moyenne 66 fournissant à sa sortie 66C une tension qui est la moyenne des tensions reçues à ses entrées 66A, 66B.

La sortie 65C de l'amplificateur différentiel 65 est reliée à chaque source de courant 22, 24 de manière à réguler l'intensité du courant I_{bias1}, I_{bias2}, délivré par chacune des sources de courant 22, 24 respectivement.

Les sources de courant 22, 24 sont par exemple des transistors, notamment transistors PMOS, la sortie 65C de l'amplificateur différentiel 25 étant reliée à la grille de chaque source de courant 22, 24.

L'amplificateur différentiel 65 régule dynamiquement le courant fourni par les sources de courant 22, 24 en fonction de la différence entre la tension moyenne VAV et la tension de commande VCM. Il compense ainsi les dérives de mode commun, telle que la variation de température. En cas de changement de température, la tension à l'entrée de chaque jauge 12, 14 (ou à la sortie de chaque source de courant 22, 24) varie mais la différence de tension est maintenue constante.

Le courant de polarisation I_{bias} est réglé initialement en jouant sur VCM et/ou VREF de telle manière que I_{bias}= (VCM - VREF)/R_{J} où R_{J} représente la résistance ohmique des jauges 12, 14.

Dans le mode de réalisation venant d'être décrit en détail, la nanofil de silicium est polarisé en courant. Une description similaire pourrait être faite en utilisant un dispositif dans lequel le nanofil de silicium est polarisé en tension.

Bien évidemment, la partie sensible du dispositif présenté ici comporte deux jauges, mais l'invention fonctionne quel que soit le nombre de nanofils de silicium utilisé.

## Revendications

1. Procédé d'optimisation de la consommation électrique d'un dispositif (10) résistif du type comportant :
- au moins une jauge (12,14) de contrainte à nanofils de silicium,
- un moyen d'alimentation (16) comportant au moins une source de courant (22, 24) propre à générer un courant de polarisation (Ibias ) de la jauge, et
- des moyens d'acquisition (18) propres à délivrer un signal de mesure à partir duquel la variation de la résistance électrique de la jauge peut être déterminée,
le moyen d'alimentation comportant un moyen de hachage (26) propre à ne faire circuler le courant de polarisation généré par la ou chaque source de courant à travers la ou chaque jauge uniquement pendant une fraction d'un cycle de fonctionnement du dispositif, **caractérisé en ce que** ledit procédé comporte les étapes consistant à :
- définir une consommation totale acceptable pour le dispositif (10) ;
- calculer la valeur du courant de polarisation de manière à ce que la fréquence supérieure (fmax) de la bande passante d'intérêt du signal de mesure corresponde à la fréquence de coin (fc) du bruit de fond affectant le dispositif ;
- régler le moyen de hachage de manière à ce que le rapport cyclique d'alimentation des jauges conduise à un rapport signal sur bruit prédéterminé pour le dispositif ;
- calculer la consommation électrique de ladite au moins une jauge (12, 14) compte tenu de la valeur du courant de polarisation calculée et de la valeur du rapport cyclique déterminée ;
- évaluer la différence entre la consommation totale acceptable et la consommation de ladite au moins une jauge et affecter cette différence en tant que contrainte pour l'élaboration des moyens électroniques d'acquisition (18).

2. Procédé d'utilisation d'un dispositif (10) résistif optimisé suivant la revendication 1, le dispositif résistif comportant :
- au moins une jauge (12,14) de contrainte à nanofils de silicium,
- un moyen d'alimentation (16) comportant au moins une source de courant (22, 24) propre à générer un courant de polarisation (Ibias ) de la jauge, et
- des moyens d'acquisition (18) propres à délivrer un signal de mesure à partir duquel la variation de la résistance électrique de la jauge peut être déterminée,
le moyen d'alimentation comportant un moyen de hachage (26) propre à ne faire circuler le courant de polarisation généré par la ou chaque source de courant à travers la ou chaque jauge uniquement pendant une fraction d'un cycle de fonctionnement du dispositif" **caractérisé en ce que** ledit procédé comporte une étape de calcul de la valeur du courant de polarisation de sorte que la fréquence supérieure (fmax) de la bande passante d'intérêt du signal de mesure délivré par le dispositif résistif corresponde à la fréquence de coin (fc) du bruit de fond affectant le dispositif, et une étape de réglage dudit moyen d'alimentation de manière à ce que le courant de polarisation dans la jauge soit égal au courant de polarisation calculé.

3. Procédé selon la revendication 2, **caractérisé en ce qu'**il comporte une étape de réglage dudit moyen de hachage de manière à ce que le rapport cyclique d'alimentation de la jauge corresponde à un rapport signal sur le bruit prédéterminé.

4. Procédé selon l'une quelconque des revendications précédentes, **caractérisé en ce que** ledit moyen de hachage dudit dispositif comporte un moyen de réglage du rapport cyclique propre à ajuster ladite fraction d'un cycle de fonctionnement à une valeur inférieure à 75%, de préférence inférieure à 50%, notamment égale à 25%.

5. Procédé selon l'une quelconque des revendications précédentes, **caractérisé en ce que** la fréquence inférieure de la bande passante d'intérêt du signal de mesure délivré par le dispositif résistif correspond sensiblement à la fréquence nulle (fmin).

6. Procédé selon l'une quelconque des revendications précédentes, **caractérisé en ce que** les moyens d'acquisition dudit dispositif comportent un étage d'amplification (58, 56), un moyen de filtrage (62) et un moyen de numérisation (64).

7. Procédé selon l'une quelconque des revendications précédentes, **caractérisé en ce que** ledit dispositif comporte deux jauges de contrainte à nanofils de silicium intégrées dans un montage électrique du type différentiel.

8. Procédé selon la revendication 7, **caractérisé en ce que** le moyen d'alimentation du dispositif comporte deux sources de courant (22, 24), chacune propre à générer un courant de polarisation d'une jauge.

9. Procédé selon la revendication 8, **caractérisé en ce que** le moyen d'alimentation du dispositif comporte, en outre, un moyen de stabilisation par découpage (28), et en ce quel les moyens d'acquisition (18) comportent un moyen de démodulation (60) placé entre l'étage d'amplification et le moyen de filtrage, les signaux de commande (D0, D1) de l'étage de démodulation étant corrélés aux signaux de commande (M0, M1) du moyen de stabilisation par découpage et/ou du moyen de hachage.

10. Procédé selon l'une quelconque des revendications 7 à 9, **caractérisé en ce que** ledit montage électrique des deux jauges est à compensation du mode commun.

11. Procédé selon l'une quelconque des revendications 7 à 10, **caractérisé en ce que** ldit dispositif comprend un amplificateur différentiel (65) à deux entrées et une sortie, une entrée recevant la tension moyenne des entrées des jauges (12, 14) ou des sorties des sources de courant (22, 24), l'autre entrée recevant une tension de commande, et la sortie étant reliée à chaque source de courant (22, 24) de telle manière à réguler l'intensité du courant délivré par chacune des sources de courant (22, 24).

12. Procédé selon l'une quelconque des revendications précédentes, **caractérisé en ce que** ledit dispositif est un capteur inertiel.

## Patentansprüche

1. Verfahren zum Optimieren des Stromverbrauchs einer Widerstandsvorrichtung (10) des Typs mit:
- mindestens einem Dehnungsmessgerät (12, 14) mit Nanodrähten aus Silicium,
- einer Versorgungseinrichtung (16) mit mindestens einer Stromquelle (22, 24), die sich dazu eignet, einen Polarisationsstrom (Ibias) des Messgeräts zu erzeugen, und
- Erfassungseinrichtungen (18), die sich dazu eignen, ein Messsignal auszugeben, aus dem die Veränderung des elektrischen Widerstands des Messgeräts bestimmt werden kann,
wobei die Versorgungseinrichtung eine Chopper-Einrichtung (26), die sich dazu eignet, den von der oder jeder Stromquelle erzeugten Polarisationsstrom nur während eines Bruchteils eine Funktionszyklus der Vorrichtung durch das oder jedes Messgerät fließen zu lassen, **dadurch gekennzeichnet, dass** das Verfahren die Schritte umfasst, die darin bestehen:
- einen akzeptablen Gesamtverbrauch für die Vorrichtung (10) zu definieren;
- den Wert des Polarisationsstroms so zu berechnen, dass die höchste Frequenz (fmax) des Durchlassbands von Interesse des Messsignals der Eckfrequenz (Fc) des die Vorrichtung beeinflussenden Hintergrundrauschens entspricht;
- die Chopper-Einrichtung so einzustellen, dass das zyklische Versorgungsverhältnis der Messgeräte zu einem für die Vorrichtung vorbestimmten Signal-/Rauschverhältnis führt;
- den Stromverbrauch des mindestens einen Messgeräts (12, 14) unter Berücksichtigung des berechneten Werts des Polarisationsstroms und des bestimmten Werts des zyklischen Verhältnisses zu berechnen;
- die Differenz zwischen dem akzeptablen Gesamtverbrauch und dem Verbrauch des mindestens einen Messgeräts auszuwerten und diese Differenz als Zwangsbedingung für die Ausarbeitung der elektronischen Erfassungseinrichtungen (18) vorzugeben.

2. Verfahren zur Nutzung einer optimierten Widerstandsvorrichtung (10) nach Anspruch 1, wobei die Widerstandsvorrichtung umfasst:
- mindestens ein Dehnungsmessgerät (12, 14) mit Nanodrähten aus Silicium,
- eine Versorgungseinrichtung (16) mit mindestens einer Stromquelle (22, 24), die sich dazu eignet, einen Polarisationsstrom (Ibias) des Messgeräts zu erzeugen, und
- Erfassungseinrichtungen (18), die sich dazu eignen, ein Messsignal auszugeben, aus dem die Veränderung des elektrischen Widerstands des Messgeräts bestimmt werden kann,
wobei die Versorgungseinrichtung eine Chopper-Einrichtung (26), die sich dazu eignet, den von der oder jeder Stromquelle erzeugten Polarisationsstrom nur während eines Bruchteils eine Funktionszyklus der Vorrichtung durch das oder jedes Messgerät fließen zu lassen, **dadurch gekennzeichnet, dass** das Verfahren einen Schritt, um den Wert des Polarisationsstroms so zu berechnen, dass die höchste Frequenz (fmax) des Durchlassbands von Interesse des von der Widerstandsvorrichtung ausgegebenen Messsignals der Eckfrequenz (Fc) des die Vorrichtung beeinflussenden Hintergrundrauschens entspricht, und einen Schritt umfasst, die Versorgungseinrichtung so einzustellen, dass der Polarisationsstrom im Messgerät gleich dem berechneten Polarisationsstrom ist.

3. Verfahren nach Anspruch 2, **dadurch gekennzeichnet, dass** es einen Schritt umfasst, die Chopper-Einrichtung so einzustellen, dass das zyklische Versorgungsverhältnis des Messgeräts zu einem vorbestimmten Signal-/Rauschverhältnis führt.

4. Verfahren nach einem der vorhergehenden Ansprüche, **dadurch gekennzeichnet, dass** die Chopper-Einrichtung der Vorrichtung eine Einrichtung zur Einstellung des zyklischen Verhältnisses umfasst, die sich dazu eignet, den Bruchteil eines Funktionszyklus auf einen Wert unter 75%, vorzugsweise unter 50%, insbesondere auf gleich 25% einzustellen.

5. Verfahren nach einem der vorhergehenden Ansprüche, **dadurch gekennzeichnet, dass** die untere Frequenz des Durchlassbands von Interesse des von der Widerstandsvorrichtung ausgegebenen Messsignals im Wesentlichen der Nullfrequenz (min) entspricht.

6. Verfahren nach einem der vorhergehenden Ansprüche, **dadurch gekennzeichnet, dass** die Erfassungseinrichtungen der Vorrichtung eine Verstärkerstufe (58, 56), eine Filtereinrichtung (62) und eine Digitalisierungseinrichtung (64) umfassen.

7. Verfahren nach einem der vorhergehenden Ansprüche, **dadurch gekennzeichnet, dass** die Vorrichtung zwei in eine elektrische Schaltungsanordnung des Differentialtyps integrierte Dehnungsmessgeräte mit Nanodrähten aus Silicium umfasst.

8. Verfahren nach Anspruch 7, **dadurch gekennzeichnet, dass** die Versorgungseinrichtung der Vorrichtung zwei Stromquellen (22, 24) umfasst, wovon sich jede dazu eignet, einen Polarisationsstrom eines Messgeräts zu erzeugen.

9. Verfahren nach Anspruch 8, **dadurch gekennzeichnet, dass** die Versorgungseinrichtung der Vorrichtung darüber hinaus eine Aufteilungsstabilisierungseinrichtung (28) umfasst, und dass die Erfassungseinrichtungen (18) eine Demodulationseinrichtung (60) umfassen, die zwischen der Verstärkerstufe und der Filtereinrichtung eingesetzt ist, wobei die Steuersignale (D0, D1) der Demodulationsstufe mit den Steuersignalen (M0, M1) der Aufteilungsstabilisierungseinrichtung und/oder der Chopper-Einrichtung korreliert werden.

10. Verfahren nach einem der Ansprüche 7 bis 9, **dadurch gekennzeichnet, dass** die elektrische Schaltungsanordnung der zwei Messgeräte mit Gleichtaktkompensation ist.

11. Verfahren nach einem der Ansprüche 7 bis 10, **dadurch gekennzeichnet, dass** die Vorrichtung einen Differenzverstärker (65) mit zwei Eingängen und einem Ausgang umfasst, wobei ein Eingang die mittlere Spannung der Eingänge der Messgeräte (12, 14) oder der Ausgänge der Stromquellen (22, 24) erhält, wobei der andere Eingang eine Steuerspannung erhält, und der Ausgang an jede Stromquelle (22, 24) angeschlossen wird, um die Stärke des von jeder der Stromquellen (22, 24) ausgegebenen Stroms einzustellen.

12. Verfahren nach einem der vorhergehenden Ansprüche, **dadurch gekennzeichnet, dass** die Vorrichtung ein Trägheitssensor ist.

## Claims

1. A method for optimising the power consumption of a resistive device (10) of the type comprising :
- at least one silicon nanowire strain gauge (12, 14),
- a power supply means (16) comprising at least one current source (22, 24) able to generate a current (I_{bias}) for biasing the gauge, and
- an acquisition means (18) able to deliver a measurement signal which can be used to determine the variation of an electrical resistance of the gauge,
the power supply means comprises a chopping means (26), capable of allowing the biasing current generated by the or each current source to flow through the or each gauge only during a fraction of an operating cycle of the device, **characterised in that** said method comprises the following steps of:
- defining an acceptable total consumption for the device (10);
- calculating the value of a biasing current in a manner such that the upper frequency (fmax) of the bandwidth of interest for the measurement signal corresponds to a corner frequency (fc) of a background noise affecting the device;
- adjusting the chopping means in a manner such that the power supply duty cycle ratio of the gauges leads to a predetermined signal to noise ratio for the device;
- calculating the power consumption of said at least one gauge (12, 14) taking into account the calculated value of the biasing current and the value of the duty cycle determined;
- evaluating a difference between the total acceptable consumption and the consumption of the said at least one strain gauge and assigning this difference as a constraint for the development of the electronic acquisition means (18).

2. A method of use of a resistive device (10) optimised according to claim 1, the resistive device comprising:
- at least one silicon nanowire strain gauge (12, 14),
- a power supply means (16) comprising at least one current source (22, 24) able to generate a current (I_{bias}) for biasing the gauge, and
- an acquisition means (18) able to deliver a measurement signal which can be used to determine the variation of an electrical resistance of the gauge,
the power supply means comprises a chopping means (26), capable of allowing the biasing current generated by the or each current source to flow through the or each gauge only during a fraction of an operating cycle of the device, **characterised in that** said method includes a step of calculating the value of the biasing current in a manner such that an upper frequency (fmax) of a bandwidth of interest for the measurement signal delivered by the resistive device corresponds to a corner frequency (fc) of a background noise affecting the device, and a step of adjusting the said power supply means in a manner such that the biasing current in the gauge is equal to the calculated biasing current.

3. A method according to claim 2, **characterised in that** it comprises a step of adjusting the said chopping means in a manner such that the power supply duty cycle ratio of the gauge corresponds to a predetermined signal to noise ratio.

4. A method according to any one of preceding claims, **characterised in that** the said chopping means of said device comprises a means for adjusting the duty cycle ratio, capable of adjusting said fraction of an operating cycle of the device to a value less than 75%, preferably less than 50%, in particular equal to 25%.

5. A method according to any one of the preceding claims, **characterised in that** the lower frequency of the bandwidth of interest for the measurement signal delivered by the device substantially corresponds to a zero frequency (fmin).

6. A method according to any one of the preceding claims, **characterised in that** the acquisition means comprise a stage of amplification (58, 56), a means for filtering (62) and a means for digitising (64).

7. A method according to any one of the preceding claims, **characterised in that** it comprises two silicon nanowire strain gauges incorporated in an electrical circuit of the differential type.

8. A method according to claim 7, **characterised in that** the power supply means comprises two current sources (22, 24), each capable of generating a current for biasing one of the gauges.

9. A method according to claim 8, **characterised in that** the power supply means further comprises a means for stabilisation by switching (28), and **in that** the acquisition means (18) comprises a demodulation means (60) positioned between the stage of amplification and the filtering means, the control signals (D0, D1) of the demodulation stage being correlated with the control signals (M0 , M1) of the means for stabilisation by switching and / or of the chopping means.

10. A method according to any one of claims 7 to 9, **characterised in that** the said electrical circuit arrangement of the two gauges allows a common mode compensation.

11. A method according to any one of claims 7 to 10, **characterised in that** it comprises a differential amplifier (65) having two inputs and one output, one input receiving the average voltage of the inputs of the gauges (12, 14) or the outputs of the current sources (22, 24), the other input receiving a control voltage, and the output being connected to each current source (22, 24) in a manner so as to regulate the intensity of the current delivered by each of the current sources (22, 24).

12. A method according to any one of the preceding claims, **characterised in that** it is an inertial sensor.
